Europäisches Patentamt

European Patent Office

Office européen des brevets

(19)

(11) Veröffentlichungsnummer: **0 022 285**
**B1**

(12) # EUROPÄISCHE PATENTSCHRIFT

(45) Veröffentlichungstag der Patentschrift:
15.02.84

(51) Int. Cl.³: **F 16 C 33/12,** C 23 C 11/00,
H 01 J 35/10

(21) Anmeldenummer: 80200549.6

(22) Anmeldetag: 13.06.80

(54) Trockengeschmiertes Gleitlager, Verfahren zu seiner Herstellung und seine Verwendung.

(30) Priorität: 28.06.79 DE 2926080

(43) Veröffentlichungstag der Anmeldung:
14.01.81 Patentblatt 81/2

(45) Bekanntmachung des Hinweises auf die Patenterteilung:
15.02.84 Patentblatt 84/7

(84) Benannte Vertragsstaaten:
AT CH DE FR GB LI NL

(56) Entgegenhaltungen:
GB - A - 907 791
GB - A - 1 311 854

THIN SOLIDE FILMS, Band 58, Nr. 1, März 1979,
Lausanne; C. WEISSMANTEL "Film Preparation Using
Plasma or Ion Activation", Seiten 101 bis 105
THIN SOLID Films, Band 50, Nr. 1, Mai 1978, Lausanne;
F.V. BERNUS et al. "Vapour-Deposited Films and
Industrial Applications", Seiten 39 bis 48
THIN SOLID FILMS, Band 35, 1976, Lausanne; D.S.
WHITMELL et al. "The Deposition of Hard Surface
Layers by Hydrocarbon Cracking in a Glow Discharge",
Seiten 255 bis 261
THIN SOLID FILMS, Band 38, 1976, Lausanne, L.
HOLLAND et al. "Deposition of Hard and Insulating
Carbonaceous Films on an r.f. Target in a Butane
Plasma", Seiten L17 bis L19

(73) Patentinhaber: Philips Patentverwaltung GmbH,
Billstrasse 80, D-2000 Hamburg 28 (DE)
(84) Benannte Vertragsstaaten: DE

(73) Patentinhaber: N.V. Philips' Gloeilampenfabrieken,
Groenewoudseweg 1, NL-5621 BA Eindhoven (NL)
(84) Benannte Vertragsstaaten: CH FR GB LI NL AT

(72) Erfinder: Dimigen, Heinz, Dr., Olshausenstrasse 5,
D-2000 Hamburg 52 (DE)
Erfinder: Hübsch, Hubertus, Lentersweg 61,
D-2000 Hamburg 63 (DE)

(74) Vertreter: Auer, Horst, Dipl.-Ing., Philips
Patentverwaltung GmbH
Billstrasse 80 Postfach 10 51 49,
D-2000 Hamburg 28 (DE)

Trockengeschmiertes Gleitlager, Verfahren zu seiner Herstellung und seine Verwendung

Die Erfindung bezieht sich auf eine Kohlenstoff enthaltende Gleitschicht zwischen sich gegeneinander oder aufeinander bewegenden Flächen (Gleitflächen).

Zur Verminderung des Reibungswiderstandes fester Gleitflächen werden Schmiermittel eingesetzt, die den Materialverschleiss und den Energieverbrauch herabsetzen.

Bei der Reibung fester Gleitflächen ist die Reibungs- oder Tangentialkraft K abhängig vom Reibungskoeffizienten $\mu$ der Gleitflächen und der Belastung P, mit der die Gleitflächen aufeinander oder gegeneinander reiben: $K = \mu \cdot P$.

Unter Gleitfläche ist die Oberfläche eines Werkstückes zu verstehen, die unter einer gewissen Anpresskraft auf einer Gegenfläche eines anderen Werkstücks gleitet.

Der Reibungskoeffizient $\mu$ ist von der Oberflächenrauhigkeit der reibenden Flächen, bei glatten Flächen jedoch von der Stoffpaarung, also vom Gleitflächenmaterial, abhängig. Es ist bekannt, den Reibungskoeffizienten der trockenen Reibung durch Überziehen der Gleitflächen mit andersartigen Substanzen zu verändern, um die Reibung zu vermindern und den Verschleiss der reibenden Flächen herabzusetzen.

Die bekannten Trockenschmiermittel bilden auf Grund ihrer Materialeigenschaften unterschiedliche Gruppen:

1. Stoffe, die auf Grund einer schuppenförmigen Kristallstruktur gute Gleitreibungseigenschaften haben, wie z.B. Graphit oder auch die Chalkogenide von Metallen wie Molybdän, Wolfram und Niob;

2. duktile Metalle wie Gold, Silber, Blei oder Zinn;

3. Hartstoffe wie Silicide, Boride, Nitride oder Carbide.

Die genannten Stoffe können lose zwischen den Gleitflächen angeordnet oder fest in Form von dünnen Schichten mit Hilfe von in der Dünnschichttechnologie üblichen Verfahren wie z.B. Aufdampfen im Vakuum oder Kathodenzerstäubung auf den Gleitflächen angebracht sein.

Alle diese Trockenschmierstoffe haben ihre besonderen Vorteile und Nachteile.

Ein spezieller Nachteil von Graphit als Trockenschmierstoff ist, dass er unter atmosphärischen Bedingungen zwar einen niedrigen Gleitreibungskoeffizienten ($\mu \cong 0,1-0,2$) hat, was erwünscht ist, in trockener Atmosphäre jedoch einen stark erhöhten Gleitreibungskoeffizienten ($\mu \cong 0,8$) zeigt; dies hat zur Folge, dass der Verschleiss der reibenden Flächen in trockener Atmosphäre gross ist, da der Graphit ein sehr weiches, d.h. wenig abriebfestes Material ist, und die Reibung darüberhinaus durch den erhöhten Gleitreibungskoeffizienten des Graphits erhöht ist.

Mit Chalkogeniden der obengenannten Art können Reibungsprobleme bei nicht zu hohen Temperaturen gut gelöst werden, problematisch wird die Anwendung dieser Materialien jedoch bei höheren Temperaturen. $MoS_2$ z.B. zersetzt sich in Luft bei Temperaturen oberhalb 400°C. Eine derartige chemische Nicht-Beständigkeit begrenzt also den Einsatz von Materialien, die grundsätzlich als Trockenschmierstoff gut geeignet wären. $MoS_2$ hat ausserdem im Gegensatz zu Graphit in trockener Atmosphäre einen sehr niedrigen Gleitreibungskoeffizienten ($\mu \cong 0,04$), unter normalen atmosphärischen Bedingungen steigt der Gleitreibungskoeffizient $\mu$ jedoch auf $\sim 0,2$ an.

Ein genereller Nachteil bei Materialien mit schuppenförmiger Struktur, – was für Graphit wie auch für $MoS_2$ gilt – ist überdies ihre mangelnde Abriebfestigkeit sowie ihre geringe Härte.

Duktile Metalle wie Gold, Silber, Blei und Zinn sind gute Trockenschmierstoffe, da diese Materialien verhältnismässig niedrige Gleitreibungskoeffizienten haben ($\mu \cong 0,2-0,4$). Da diese Metalle jedoch sehr weich sind – was ihnen anderseits ihre guten Gleiteigenschaften gibt – haben auch sie eine nur geringe Abriebfestigkeit.

Um nun Gleitschichten höherer Abriebfestigkeit zu erhalten, sind Materialien grösserer Härte, wie Silicide, Boride, Nitride und Carbide an Gleitflächen eingesetzt worden.

Es hat sich gezeigt, dass mit diesen Materialien grösserer Härte zwar eine gute Abriebfestigkeit erreicht werden kann, die Gleitreibungskoeffizienten liegen hier jedoch mit Werden von $\mu \cong 0,3$ bis 0,7 weit über den Werten der wegen ihrer niedrigen Gleitreibungskoeffizienten als Trockenschmierstoff gut geeigneten Materialien Graphit ($\mu \cong 0,1-2$) oder Molybdändisulfid $MoS_2$ ($\mu \cong 0,04$).

Der Vollständigkeit halber wird darauf hingewiesen, dass aus der GB-A-907 791 ein Verfahren bekannt war, nach welchem ein Festfressen von Reibpartnern aus Material gleicher oder nahezu gleicher Härte, z.B. Stahl, vermieden und die Abriebfestigkeit der Reibpartner erhöht werden soll, indem in die reibenden Oberflächen einzelne Hartstoffpartikel, z.B. Diamant, Saphir, Rubin, Silicium, Carbide oder Korund, mechanisch eingearbeitet werden. Es handelt sich hierbei nicht um das Aufbringen einer homogenen Oberflächenschicht, die möglichst niedrige Reibungsbeiwerte haben soll, sondern eine reibende Oberfläche erhält durch Einbau von Hartstoffpartikeln einen inhomogenen Materialaufbau und wird durch die Hartstoffe verschleissfester.

Der Erfindung liegt die Aufgabe zugrunde, eine Gleitschicht für sich gegeneinander oder aufeinander bewegende Flächen zu schaffen mit in Normalatmosphäre wie auch in trockener Atmosphäre einem Gleitreibungskoeffizienten in der Grössenordnung der des Graphits oder Molybdändisulfids in trockener Atmosphäre, die darüber hinaus aber eine hohe Abriebfestigkeit und Härte unabhängig von der Art der Atmosphäre vergleichbar der der Hartstoffe wie Boride, Silicide, Nitride und Carbide aufweist.

Diese Aufgabe wird erfindungsgemäss dadurch gelöst, dass die Gleitschicht eine auf mindestens einer der Gleitflächen (Substrat) festhaftend angebrachte 10 nm bis 10 µm dicke Schicht aus Kohlenstoff mit diamantähnlicher Struktur ist.

Überraschenderweise hat sich gezeigt, dass besonders gute Gleitreibungskoeffizienten nicht notwendigerweise an eine schuppenförmige Struktur des Trockenschmierstoffes gebunden sind, wie bisher angenommen wurde. Die besonders guten Gleitreibungseigenschaften der Materialien mit schuppenförmiger Struktur werden bekannterweise darauf zurückgeführt, dass die Atomabstände in der Lamellenebene kleiner sind als senkrecht dazu. Da die Kohäsionskräfte in hohem Masse von den Atomabständen abhängen (sie nehmen mit zunehmendem Abstand nach einem Potenzgesetz ab), ergibt sich zwischen den Gleitebenen ein geringerer Reibungskoeffizient als bei der relativ grossen Kohäsion z.B. der meisten Metalle. Offenbar hängen gute Gleitreibungseigenschaften jedoch noch von anderen, noch nicht definierten Parametern ab, wie die Gleitschicht mit diamentähnlicher Struktur gemäss der Erfindung zeigt.

Nach einer bevorzugten Ausführungsform der Erfindung ist zwischen der Gleitschicht und dem Substrat eine die Haftung der Gleitschicht verbessernde Zwischenschicht angebracht, die vorzugsweise eine ähnliche Gitterstruktur hat wie die Gleitschicht.

Die Zwischenschicht kann aus Silicium oder Siliciumdioxid bestehen. Hiermit ist der Vorteil verbunden, dass die Haftfestigkeit der Gleitschicht an der Gleitfläche (Substrat) erheblich verbessert werden kann, insbesondere, wenn die Gleitflächen aus Stahl bestehen.

Zur Herstellung der Gleitschicht wird vorzugsweise ein Verfahren angewendet, bei dem die Gleitschicht in einem plasmaaktivierten Abscheidungsprozess aus der Gasphase (chemical vapour deposition) auf das zu beschichtende Substrat aufgebracht wird, derart, dass dem Substrat eine elektrische Vorspannung bis zu einigen kV erteilt wird und die Gasatmosphäre, aus der die Gleitschicht abgeschieden wird, gasförmige Kohlenwasserstoffe enthält.

Vorzugsweise wird als Kohlenwasserstoff Acetylen eingesetzt.

Die mit der Erfindung erzielten Vorteile bestehen insbesondere darin, dass Gleitschichten dargestellt werden können, die unter Vakuum- oder Inertgasbedingungen einen besonders niedrigen Gleitreibungskoeffizienten µ in der Grössenordnung von 0,01 bis 0,02 bei gleichzeitig einer sehr hohen Abriebfestigkeit und Härte aufweisen, was von Vorteil sein kann z.B. bei der Verwendung in Drehanoden-Röntgenröhren.

Ein weiterer Vorteil ist, dass diese Schichten auch unter normalen atmosphärischen Bedingungen (bei einer relativen Luftfeuchte von 50%) Gleitreibungskoeffizienten aufweisen, die mit µ von 0,08 bis 0,1 niedriger sind als die des für Schmierzwecke unter normalen atmosphärischen Bedingungen als optimal bekannten Trocken-

schmierstoffes $MoS_2$ mit Werten für den Gleitreibungskoeffizienten µ von 0,1 bis 0,2.

Die Gleitschicht gemäss der Erfindung ist besonders gut geeignet, wenn mindestens eine der Gleitflächen, also ein Reibpartner, Stahl ist. Da die meisten schmiertechnischen Probleme sich im Bereich von Stahloberflächen ereignen, liegt hier ein bevorzugtes Anwendungsgebiet für die Gleitschichten gemäss der Erfindung.

Anhand der Zeichnung wird ein Ausführungsbeispiel der Erfindung beschrieben und ihre Wirkungsweise erläutert.

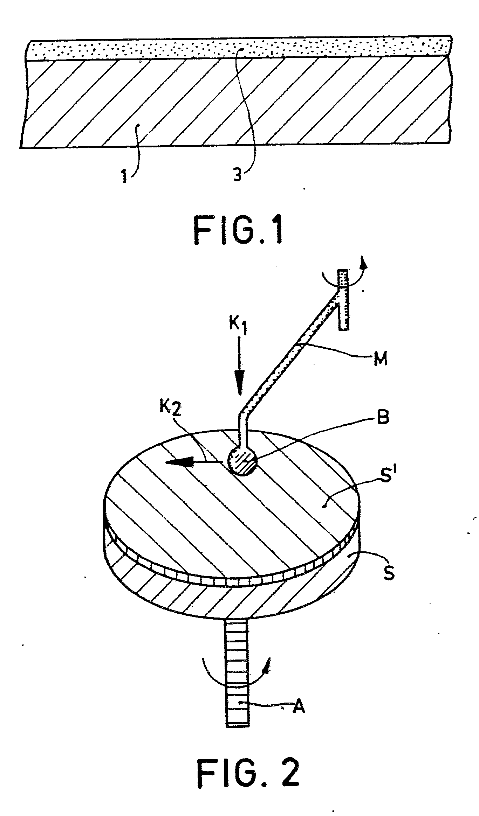

Fig. 1 zeigt ein mit einer Gleitschicht gemäss der Erfindung beschichtetes Substrat im Schnitt,

Fig. 2 zeigt eine schematische Darstellung eines Messgerätes zur Messung des Gleitreibungskoeffizienten nach dem Stand der Technik.

Auf einem Substrat 1, hier eine Siliciumscheibe eines Durchmessers von 50 mm und einer Dicke von 0,25 mm wurde eine Kohlenstoffschicht diamantähnlicher Struktur und einer Schichtdicke von ~ 1 µm angebracht. Die Abscheidung erfolgte in an sich bekannter Weise aus der Gasphase durch einen plasmaaktivierten Abscheidungsprozess, wobei dem zu beschichtenden Substrat eine Vorspannung von 100 V erteilt wurde. Das Substrat ist dabei auf einer Elektrode in einer konventionellen Hochvakuumapparatur, wie sie z.B. auch für HF-Kathodenzerstäubungsverfahren angewendet wird, angeordnet. Nach Evakuieren bis in den Hochvakuumbereich $(1,33 \cdot 10^{-3}$ Pa) wird die Anlage mit den für den Abscheidungsprozess erforderlichen Gasen beschickt. Es ist einmal erforderlich, für die Bildung der Schicht Kohlenstoff in der Gasphase zu haben, zum anderen muss aber auch Energie mittels Ionen übertragen werden.

Es kann im Prinzip so vorgegangen werden, dass die Beschichtung mit energiereichen Kohlenstoffionen, z.B. mit einem Molekularstrahl einer höheren Energie, ausgeführt wird.

Für die industrielle Praxis ist es jedoch wirtschaftlicher, Gase zu verwenden, die nach Aufspaltung im Plasma einmal Kohlenstoff liefern und zum anderen energiereiche Ionen. Bei dem vorliegenden Ausführungsbeispiel wurde als Kohlenstoff lieferndes Gas Acetylen mit einem Druck von ca. 130 Pa angewendet. Die zur Abscheidung notwendige Anregung des Gases wurde durch Anlegen einer Hochfrequenzspannung an die das Substrat tragende Elektrode erreicht. Die Gleichstromvorspannung am Substrat betrug dabei ca. 100 V.

Bei dem Verfahren, nach welchem die Schichten gemäss der Erfindung präpariert wurden, handelt es sich um ein bekanntes Verfahren, das z.B. in den Arbeiten von D.S. Whitmell und R. Williamson in Thin Solid Films 35 (1976), Seite 255 oder von L. Holland und S.M. Ojha in Thin Solid Films 38 (1976), L17 beschrieben wurde.

Die Reibungseigenschaften sowie die Härte der niedergeschlagenen Kohlenstoffschichten gemäss der Erfindung sind in der nachfolgenden Tabelle im Vergleich zu den entsprechenden Werten anderer, bekannter Trockenschmierstoffe dargestellt.

Die gemessenen Gleitreibungskoeffizienten wurden mit Hilfe einer bekannten Stift-Scheibe-Apparatur (pin on disk) ermittelt. Ein derartiges Messgerät ist in Fig. 2 dargestellt: Ein mit einer zu messenden Schicht S' beschichtetes Substrat S befindet sich in einer Halterung und wird um eine Achse A gedreht. Eine an einem beweglichen Arm M befestigte Kugel B (sie besteht meistens aus Stahl) wird mit einer Kraft $K_1$ auf die zu messende Schicht S' gepresst. Da die Kugel B fest eingespannt ist, findet zwischen der Kugel und der zu messenden Schicht nur Gleiten (kein Rollen) statt. Eine in Bewegungsrichtung wirkende Kraft $K_2$ wird gemessen. Der Gleitreibungskoeffizient ergibt sich als Verhältnis $K_2 : K_1$.

Tabelle

|  | Härte (N/mm²) | Gleitreibungskoeffizienten µ | |
|---|---|---|---|
| Graphit | $< 10^3$ | 0,1–0,2 | (normale Atmosphäre 50% relative Luftfeuchte) |
|  |  | $> 0,6$ | (trockene Atmosphäre) |
| Chalkogenide | $< 10^3$ | 0,02–0,05 | (trockene Atmosphäre) |
| $MoS_2$ |  | $\sim 0,2$ | (normale Atmosphäre 50% relative Luftfeuchte) |
| duktile Metalle |  |  |  |
| Silber, Blei, Gold, Zinn, Indium | $10^3 - 3 \cdot 10^3$ | 0,2–0,4 | unter Normalbedingungen |
| Hartstoffe | $15 \cdot 10^3 - 35 \cdot 10^3$ | 0,3–0,8 | unter Normalbedingungen |
| Boride |  |  |  |
| Silicide |  |  |  |
| Nitride |  |  |  |
| Carbide |  |  |  |
| Kohlenstoffschichten gemäss der Erfindung | $20 \cdot 10^3 - 35 \cdot 10^3$ | 0,01–0,02 0,08–0,1 | (trockene Atmosphäre) (normale Atmosphäre 50% relative Luftfeuchte) |

Als Ausführungsbeispiel wurde die Abscheidung einer Gleitschicht gemäss der Erfindung auf einem Siliciumsubstrat beschrieben.

Zur Verbesserung der Haftung der Kohlenstoffschicht am Substrat kann es sich jedoch empfehlen, eine Zwischenschicht zwischen dem zu beschichtenden Substrat und der Gleitschicht anzubringen.

Diese Zwischenschicht kann z.B. eine ähnliche Gitterstruktur wie die Gleitschicht haben, es haben sich jedoch auch amorphe Hartstoffe als die Haftung begünstigendes Material für die Zwischenschicht bewährt.

Auf einem Stahlsubstrat wurden bei Versuchen, die zur Erfindung geführt haben, als die Haftung erhöhende Schichten sowohl Silicium- und Siliciumdioxidschichten aber auch Titanoxicarbidschichten einer Schichtdicke von 50 nm angebracht. Die Beschichtung kann nach den aus der Dünnschichttechnologie bekannten Verfahren, z.B. durch Kathodenzerstäubung, erfolgen.

**Patentansprüche**

1. Kohlenstoff enthaltende Gleitschicht zwischen sich gegeneinander oder aufeinander bewegenden Flächen (Gleitflächen), dadurch gekennzeichnet, dass die Gleitschicht eine auf mindestens einer der Gleitflächen (Substrat) festhaftend angebrachte 10 nm bis 10 µm dicke Schicht aus Kohlenstoff mit diamantähnlicher Struktur ist.

2. Gleitschicht nach Anspruch 1, dadurch gekennzeichnet, dass sie aus einer Mehrschichtenfolge besteht, derart, dass zwischen der Gleitschicht und dem Substrat eine die Haftung der Gleitschicht verbessernde Zwischenschicht angebracht ist, die vorzugsweise eine ähnliche Gitterstruktur hat wie die Gleitschicht.

3. Gleitschicht nach Anspruch 2, dadurch gekennzeichnet, dass die Zwischenschicht aus Silicium oder Siliciumdioxid einer Schichtdicke im Bereich von 10 bis 100 nm besteht.

4. Gleitschicht nach Anspruch 2, dadurch gekennzeichnet, dass die Zwischenschicht aus einem quasi amorphen Hartstoff, vorzugsweise Titanoxicarbid, besteht.

5. Verfahren zur Herstellung der Gleitschicht nach den Ansprüchen 1 bis 4, dadurch gekennzeichnet, dass die Gleitschicht in einem plasmaaktivierten Abscheidungsprozess aus der Gasphase (chemical vapour deposition) auf das zu beschichtende Substrat aufgebracht wird, derart, dass dem Substrat eine elektrische Vorspannung bis zu einigen kV, vorzugsweise 100 V, erteilt wird und die Gasatmosphäre, aus der die Gleitschicht abgeschieden wird, gasförmige Kohlenwasserstoffe enthält.

6. Verfahren nach Anspruch 5, dadurch gekennzeichnet, dass als Kohlenwasserstoff Acetylen eingesetzt wird.

7. Verwendung der Gleitschicht gemäss den Ansprüchen 1 bis 6 in einer Drehanoden-Röntgenröhre.

**Claims**

1. A sliding layer containing carbon between surfaces (bearing surfaces) which move against or on each other, characterized in that the bearing layer is a layer of carbon with diamond-like structure 10 nm to 10 μm thick bonded to at least one of the bearing surfaces (substrate).

2. A sliding layer as claimed in claim 1, characterized in that it is a multi-layer structure, in such a way that an intermediate layer improving the adhesion of the sliding layer and preferably having a lattice structure similar to that of the sliding layer is provided between the sliding layer and the substrate.

3. A sliding layer as claimed in claim 2, characterized in that the intermediate layer consists of silicon or silicon dioxide with a layer thickness in the range from 10 to 100 nm.

4. A sliding layer as claimed in claim 2, characterized in that the intermediate layer consists of a quasi-amorphous hard substance, preferably titanium oxycarbide.

5. A method of making the sliding layer as claimed in claims 1 to 4, characterized in that the sliding layer is applied to the substrate to be coated in a plasma-activated deposition process from the gaseous phase (chemical vapour deposition) in such a way that an electrical bias voltage up to several kV, but preferably 100 V, is imparted to the substrate and the gaseous atmosphere from which the sliding layer is deposited contains gaseous hydrocarbons.

6. A method as claimed in claim 5, characterized in that acetyline is used as a hydrocarbon.

7. Use of a sliding layer as claimed in claims 1 to 6 in a rotary anode X-ray tube.

**Revendications**

1. Surface de glissement contenant du carbone entre des faces se déplaçant l'une contre l'autre ou l'une sur l'autre (surfaces de glissement), caractérisée en ce que la couche de glissement est une couche en carbone présentant une structure analogue à celle du diamant d'une épaisseur de 10 nm à 10 μm appliquée de façon adhérente sur au moins l'une des faces de glissement (substrat).

2. Couche de glissement selon la revendication 1, caractérisée en ce qu'elle est constituée par une série de plusieurs couches de façon qu'une couche intermédiaire facilitant l'adhérence de la couche de glissement soit appliquée entre la couche de glissement et le substrat et présente de préférence une structure de grille analgue à celle de la couche de glissement.

3. Couche de glissement selon la revendication 2, caractérisée en ce que la couche intermédiaire est constituée par du silicium ou du dioxyde de silicium d'une épaisseur de couche comprise entre 10 et 100 nm.

4. Couche de glissement selon la revendication 2, caractérisée en ce que la couche intermédiaire est constituée par de la matière dure quasi-amorphe, de préférence du titanoxycarbure.

5. Procédé pour la réalisation de la couche de glissement selon les revendications 1 à 4 prises ensemble, caractérisé en ce que la couche de glissement est appliquée au cours d'un processus de dépôt activé par du plasma à partir de la phase gazeuse (chemical vapour deposition) sur le substrat à recouvrir de façon qu'au substrat soit appliquée une tension de polarisation électrique jusqu'à quelques kV, de préférence 100 V et que l'atmosphère gazeuse à partir de laquelle est déposée la couche de glissement, est de l'hydrocarbure gazeux.

6. Procédé selon la revendication 5, caractérisé en ce que comme hydrocarbure est utilisé de l'acétylène.

7. Application de la couche de glissement selon les revendications 1 à 6, à un tube à rayons X à anode tournante.

FIG.1

FIG. 2